# FASCICULE DE BREVET EUROPEEN

(11) **EP 1 968 196 B1**
(45) Date de publication et mention de la délivrance du brevet: **14.06.2017**
(21) Numéro de dépôt: 08300027.3
(22) Date de dépôt: 11.01.2008
(51) Int. Cl.: H03M 1/16

(54) **PROCÉDÉ POUR NUMÉRISER UNE GRANDEUR ANALOGIQUE, DISPOSITIF DE NUMÉRISATION METTANT EN OEUVRE CE PROCÉDÉ ET DÉTECTEUR DE RAYONNEMENTS ÉLECTROMAGNÉTIQUES INTÉGRANT UN TEL DISPOSITIF**
VERFAHREN ZUR DIGITALISIERUNG EINER ANALOGEN GRÖSSE, DIGITALISIERUNGSVORRICHTUNG ZUR UMSETZUNG DIESES VERFAHRENS UND SENSOR ZUR ERKENNUNG ELEKTROMAGNETISCHER STRAHLEN, DER DIESE VORRICHTUNG UMFASST
METHOD FOR DIGITISING AN ANALOGUE MAGNITUDE, DIGITISATION DEVICE IMPLEMENTING THIS METHOD AND ELECTROMAGNETIC RADIATION DETECTOR INTEGRATING SUCH A DEVICE

(30) Priorité: 23.01.2007 FR 0752815
(43) Date de publication de la demande: 10.09.2008
(73) Titulaire: ULIS, 38113 Veurey Voroize (FR)
(72) Inventeur: Robert, Patrick, 38140 REAUMONT (FR)
(74) Mandataire: Cabinet Laurent & Charras

(56) Documents cités:
- EP-A- 0 313 460
- US-A- 4 536 744
- US-A- 4 568 913
- US-A- 5 117 227
- US-A1- 2004 034 499
- US-B1- 6 384 760
- US-B1- 7 064 694

## Description

### DOMAINE DE L'INVENTION

La présente invention concerne un procédé pour réaliser la conversion de grandeurs analogiques en signaux numériques, lesdites grandeurs étant notamment issues d'un détecteur de rayonnements électromagnétiques. La présente invention concerne également un dispositif pour réaliser une telle conversion.

La présente invention se rapporte donc plus généralement au domaine des détecteurs de rayonnements électromagnétiques, ainsi qu'à la réalisation et au fonctionnement de leur circuit de lecture.

### ETAT ANTERIEUR DE LA TECHNIQUE

De manière connue, les détecteurs de rayonnement électromagnétique sont composés d'une pluralité de capteurs élémentaires juxtaposés de manière à former une matrice présentant un certain nombre de lignes et de colonnes. Les interactions des rayonnements électromagnétiques incidents avec ces capteurs élémentaires, également dénommés pixels, génèrent des variations d'une grandeur électrique, correspondant au flux d'énergie des rayonnements incidents.

Une rétine d'imagerie infrarouge microbolométrique constitue un exemple particulier d'un tel détecteur. Dans ce cas, le détecteur fonctionne comme une thermistance sensible au rayonnement thermique, laquelle est mesurée par l'intégration du courant qui la traverse sous l'effet d'une tension de polarisation donnée pendant une durée donnée, par un circuit de lecture ménagé au niveau des capteurs élémentaires.

Les charges intégrées forment ainsi des signaux ou grandeurs de nature analogique. Afin de simplifier les interfaces électriques avec l'électronique externe au circuit de lecture, on convertit ces grandeurs analogiques sous forme de signaux numériques, pour pouvoir reconstituer une image bidimensionnelle représentative de la scène observée.

Il est connu que les performances d'un détecteur, donc la qualité des informations qu'il délivre (images numériques par exemple), dépendent notamment des caractéristiques de la conversion en signaux numériques des grandeurs analogiques représentatives des interactions entre le rayonnement incident et les capteurs élémentaires. De l'art antérieur, on connaît essentiellement trois principes de conversion de grandeurs analogiques en signaux numériques, intégrés au circuit de lecture.

Tout d'abord, il existe des détecteurs pour lesquels un unique dispositif de conversion, ou convertisseur, numérise successivement les informations analogiques émises par chacun des capteurs constituant la matrice. En général, la lecture de tels détecteurs est effectuée séquentiellement par balayage en lignes, puis en colonnes. Dans ce cas, la durée ou le temps de conversion analogique-numérique est au maximum égal à la durée de lecture d'un capteur élémentaire de la matrice de détection.

Selon un deuxième principe de conversion, chaque colonne du détecteur est équipée d'un dispositif de conversion. Le temps de conversion analogique-numérique est alors au maximum égal à la durée de lecture d'une ligne du détecteur.

Selon un troisième principe de conversion, chaque capteur du détecteur est équipé d'un tel dispositif de conversion. Le temps de conversion analogique-numérique est alors au maximum égal à la durée de lecture cumulée de tous les capteurs de la matrice.

Parmi ces différentes solutions, le choix du principe, donc du dispositif et du procédé, de conversion peut être effectué en fonction de critères tels que le temps de conversion du dispositif de conversion, sa résolution, son encombrement, sa consommation électrique etc.

En particulier, dans la deuxième solution où chaque colonne de la matrice possède son propre dispositif de conversion, l'encombrement de ce dernier doit être réduit au pas de répétition entre deux colonnes de pixels adjacentes, et dans le troisième cas, l'encombrement doit être réduit dans les deux dimensions au pas de répétition du pixel élémentaire. Le pas de répétition est en effet la distance qui sépare deux capteurs adjacents et il correspond généralement à la taille d'un pixel de l'image numérique finale.

Par ailleurs, lorsque l'on utilise plusieurs dispositifs de conversion de résolution élevée sur un même circuit, chacun des dispositifs de conversion peut être sensible aux perturbations électriques engendrées par les dispositifs de conversion voisins. En effet, plus la résolution d'un convertisseur est élevée, plus la différence de tension correspondant à deux valeurs numériques successives est faible, et en conséquence, plus il sera sensible aux perturbations extérieures. Cette sensibilité est notamment dûe à la réalisation des dispositifs de conversion, lesquels ne sont pas électriquement indépendants, mais partagent au contraire un même substrat et les mêmes masses ou les mêmes sources d'alimentation électrique.

D'autre part, le choix de l'architecture du dispositif de conversion, c'est-à-dire le nombre, la disposition et l'agencement des composants électroniques qui le composent, doit être défini de manière à minimiser la consommation électrique globale du circuit de lecture. En effet, outre le fait que l'imagerie infrarouge concerne des systèmes électroniques embarqués, où le stockage de l'énergie est une contrainte très importante, il convient également de limiter la dissipation du plan focal, car la matrice de détecteurs est par nature sensible à l'environnement thermique.

Parmi les principes de conversion mis en oeuvre dans les architectures de convertisseurs de l'art antérieur, on trouve le principe dit « de conversion tension-temps ». Cette méthode consiste à intégrer dans le temps une grandeur analogique, telle que la tension, jusqu'à ce qu'elle atteigne une valeur de référence. L'intégration est interrompue lorsque cette valeur de référence est atteinte, ce qui marque la fin de la phase d'intégration proprement dite. Dans le cas d'une intégration réalisée par un montage intégrateur classique à simple rampe et simple pente, le temps mis par cette grandeur analogique pour atteindre cette valeur de référence est alors directement proportionnel à la valeur de cette grandeur analogique.

En effet, comme le montage intégrateur est à simple pente, l'évolution de la grandeur analogique au cours du temps d'intégration est linéaire. De manière connue, il suffit donc de mesurer la durée d'intégration en nombre de périodes d'horloge de comptage, pour convertir la valeur de cette grandeur analogique, c'est-à-dire pour la numériser. Ainsi, le simple comptage du nombre d'impulsions délivré par une horloge de référence mesurant cette durée fournit directement la valeur numérique de la grandeur analogique intégrée.

Pour déterminer l'arrêt du comptage, un montage différentiel compare la grandeur analogique à la valeur de référence ; lorsque leur différence s'annule et change de signe, ce comparateur émet un signal pour figer la valeur numérique courante du compteur et déterminer ainsi la valeur de la grandeur analogique.

En pratique et de manière connue, lorsque le compteur reçoit une impulsion de l'horloge de référence, il incrémente un nombre binaire d'une unité. Par conséquent, le nombre de bits de compteur nécessaire dépend de la résolution que doit présenter le dispositif de conversion, c'est-à-dire du nombre de pas de quantification utilisés pour échantillonner la grandeur analogique maximale.
Ainsi, pour un dispositif de conversion utilisant **2^{N}** pas de quantification pour échantillonner la grandeur analogique à intégrer, le compteur doit comporter **N** bits de comptage. Le temps de conversion d'une grandeur analogique par un tel convertisseur est alors compris entre zéro et un maximum de **2^{N} / fₕ**, où **fₕ** représente la fréquence d'horloge. Donc, si **P** représente le nombre d'impulsions délivrées par l'horloge jusqu'à ce que la grandeur analogique atteigne la valeur de référence de l'étage comparateur, **P** est égal à la valeur numérique du signal et le temps de conversion de ce signal vaut **P / fₕ**.

Cependant, une telle méthode de conversion présente des inconvénients susceptibles de limiter les performances d'un tel convertisseur analogique-numérique. Ainsi, lorsque l'on souhaite augmenter sa résolution et/ou diminuer son temps de conversion, on doit utiliser une horloge délivrant des impulsions à une fréquence supérieure. Or, d'une part, il existe une limite technologique à la fréquence maximale de l'horloge et, d'autre part, on sait que la consommation électrique du convertisseur augmente avec cette fréquence et peut ainsi devenir excessive pour certaines applications.

Pour résoudre ce problème, une solution de l'art antérieur consiste à augmenter le nombre de pentes d'intégration du convertisseur, et donc à concevoir des dispositifs de conversion à simple rampe et à multiples pentes. Ainsi, dans le cas d'un dispositif de conversion à simple rampe et à double pente, la première pente d'intégration est utilisée pour définir le nombre **P** correspondant à la valeur de la grandeur analogique d'entrée avec un pas de quantification de forte valeur. Inversement, la seconde pente est utilisée pour convertir, avec un pas de quantification fin, le reliquat défini par la différence entre la valeur analogique d'entrée et la valeur analogique de valeur forte correspondant exactement au nombre **P.** Ce reliquat ou résidu correspond à une grandeur analogique faible.

En général, on distingue une première valeur numérique codée par des bits dits « de poids fort » et une deuxième valeur numérique codée par des bits dits « de poids faible ». Par abus de langage, les grandeurs analogiques intégrées sont désignées de la même façon (poids fort et poids faible) que les valeurs numériques (bits) qui les représentent après l'étape de numérisation. Par valeur numérique, on désigne ici des nombres binaires composés de « 0 » et de « 1 ».

Ainsi, le nombre **N** de bits du convertisseur est décomposé en deux « sous-nombres », à savoir un nombre correspondant aux bits de poids fort noté N_{MSB} (MSB pour « *Most Significant Bits* »), et un nombre correspondant aux bits de poids faible noté N_{LSB} (LSB pour « *Least Significant Bits* »). Par définition, la somme des deux nombres N_{MSB} et N_{LSB} vaut N, c'est-à-dire le nombre total de bits que possède le dispositif convertisseur.

De manière connue, un procédé d'intégration à deux pentes permet de réduire le temps de conversion pour un détecteur. En effet, en fonction de la valeur de la grandeur analogique à intégrer, ce temps varie entre zéro et un maximum de (2^{N_{MSB}} + **2**^{N_{LSB}})/fₕ. Ce temps est donc nécessairement inférieur au temps maximum de **2**^{N} / fₕ nécessaire pour un dispositif de conversion à simple pente.

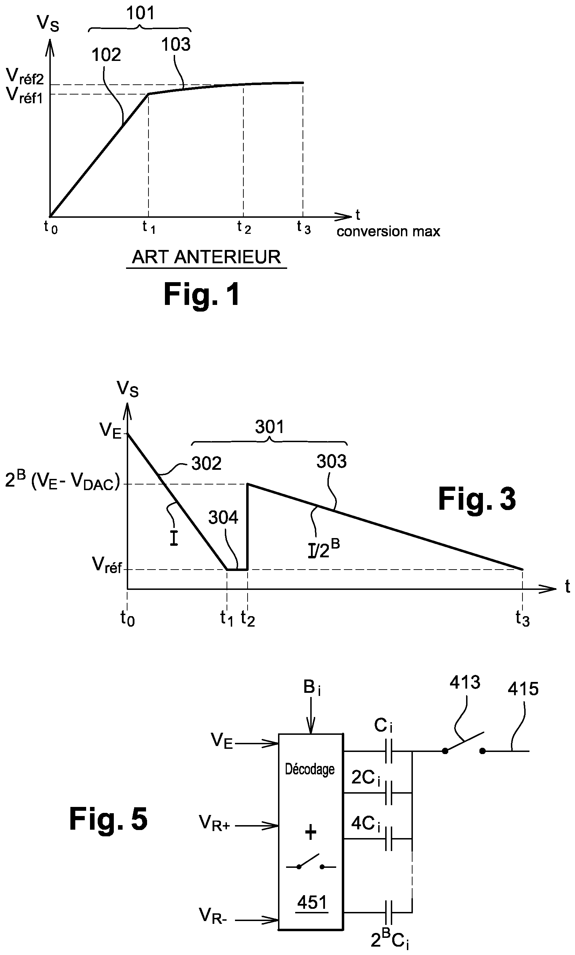

US 4 568 913 décrit les étapes et le procédé associé à une conversion analogique-numérique du type double rampe. La figure 1 représente un graphique qui illustre un procédé de conversion à simple rampe et à double pente de l'art antérieur. Sur ce graphique, l'axe des abscisses représente le temps **t**, tandis que l'axe des ordonnées représente la tension de sortie **V_{S}**, c'est-à-dire une grandeur analogique générée par les interactions entre capteurs et rayonnements, au cours de son traitement par un circuit intégrateur.

Conformément à un tel procédé de conversion à simple rampe et à double pente, la courbe **101** représente l'intégration d'une tension d'entrée **V_{E}** entrant dans le circuit intégrateur. La courbe **101** comporte une pente dite forte **102** et une pente dite faible **103.** On entend par pente « forte » une pente dont le coefficient directeur possède une forte valeur absolue, tandis qu'on entend par pente « faible » une pente dont le coefficient directeur possède une faible valeur absolue. Ainsi, la pente forte **102** représente une phase d'intégration des bits de poids fort (grandeurs analogiques fortes), tandis que la pente faible **103** représente une phase d'intégration des bits de poids faible (grandeurs analogiques faibles).

Par définition, chaque phase d'intégration se déroule pendant un intervalle de temps délimité par deux instants qui forment respectivement la borne inférieure et la borne supérieure de cet intervalle de temps. La première phase d'intégration **t₀-t₁** (pente forte **102)** est interrompue, de manière synchrone avec la fréquence d'horloge **fₕ**, lorsque la tension intégrée **V_{E}** a dépassé une valeur de référence **V_{réf}**, c'est-à-dire lorsque la différence entre la tension intégrée **V_{E}** et la valeur de référence **V_{réf}** s'est annulée. Cette condition définit ainsi la borne supérieure **t₁** de l'intervalle de temps de la première phase d'intégration **t₀-t₁.**

Selon ce procédé de conversion, la seconde phase d'intégration (pente faible **103)** débute dès la fin de la première phase d'intégration. Autrement dit, la borne inférieure **t₁** du deuxième intervalle de temps **t₁-t₂** est sensiblement confondue avec la borne supérieure **t₁** du premier intervalle de temps **t₀-t₁.** Puis, cette seconde phase d'intégration est interrompue lorsque la somme des tensions intégrées pendant les deux phases d'intégration dépasse la valeur de la tension d'entrée **V_{E}**.

Comme exposé précédemment, une durée est mesurée par le nombre d'impulsions délivrées par une horloge de référence (non représentée). Comme les courbes **102** et **103** sont des segments de droite, les impulsions d'horloge représentent donc autant de pas de quantification de la tension intégrée et, partant, cette tension intégrée elle-même. D'où la dénomination attribuée à ce type de procédé de conversion analogique-numérique « tension-temps ».

Selon ce procédé, chacune des pentes, forte **102** ou faible **103,** sert à coder un nombre représentant respectivement les bits de poids fort (MSB) et les bits de poids faible (LSB). Ces nombres permettent ainsi de reconstituer en grandeur numérique binaire une image représentative de la scène observée. Ainsi, on peut obtenir une conversion d'une grandeur analogique en signal numérique avec une résolution d'au moins douze bits et un temps de conversion de 60 µs.
Or un tel temps de conversion est compatible avec un balayage de 60 images/s pour un détecteur classiquement composé de 320 x 240 lignes. Au contraire, un procédé de conversion « tension-temps » à simple pente donnerait un temps de conversion trop long pour une telle résolution. On entend par résolution du convertisseur la capacité de celui-ci à distinguer deux tensions intégrées proches. Cette résolution est notamment choisie en fonction de l'application recherchée pour le détecteur. Bien entendu, plus cette résolution choisie sera élevée, plus la durée de conversion analogique/numérique sera importante.

En fait, la résolution ne dépend pas de la quantification de la grandeur à intégrer. De manière connue, ce pas de quantification vaut la dynamique du détecteur divisée par **2^{N}** (nombre **2** élevé à la puissance du nombre **N** de bits codant la valeur maximale de cette dynamique).

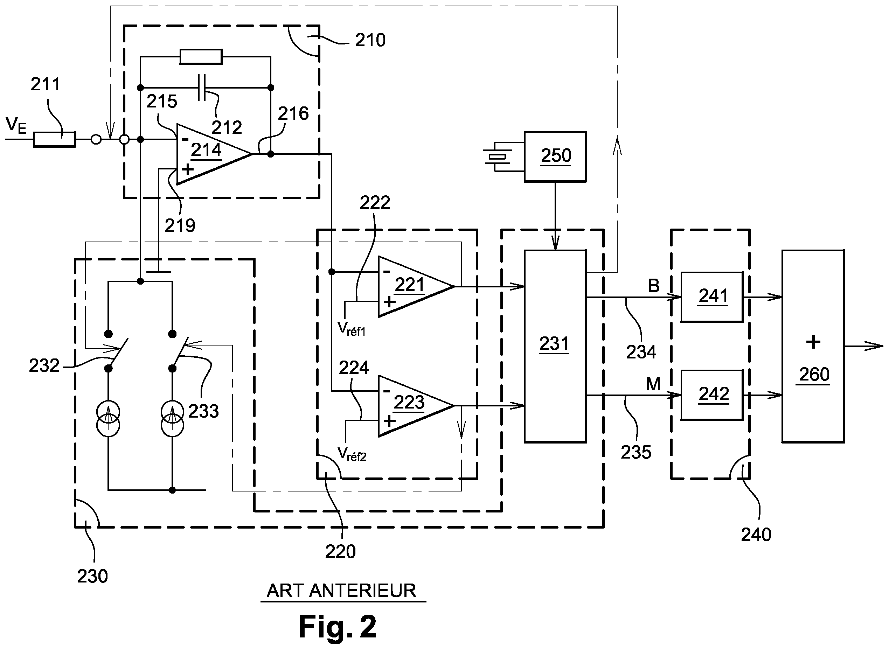

En pratique, pour réaliser ce procédé de conversion, chaque colonne d'un détecteur matriciel est équipée d'un dispositif de conversion ou convertisseur analogique-numérique. La figure 2 illustre un tel convertisseur de l'art antérieur. Il comprend successivement un étage intégrateur **210,** un étage différentiel ou comparateur **220,** un étage de commande **230** et un étage de comptage **240.**

L'étage intégrateur **210** est destiné à intégrer la tension d'entrée **V_{E}** générée par une colonne de capteurs élémentaires. L'étage différentiel **220** permet de comparer la tension intégrée **V_{E}** avec une valeur de référence **V_{réf}** de façon à déterminer une première phase d'intégration de **t₀** à **t₁**, notée **t₀**-**t₁** et une seconde phase d'intégration de **t₁** à **t₂**, notée **t₁-t₂**. L'étage de commande **230** sert à piloter l'étage intégrateur **210,** de manière à réaliser successivement les deux phases d'intégration, à pente forte **102** et à pente faible **103.** Enfin, l'étage de comptage **240** permet de compter le nombre d'impulsions délivrées par une horloge **250** pendant chacune de ces phases d'intégration **t₀-t₁** puis **t₁-t₂** et, partant, de quantifier la tension intégrée **V_{E}**.

De manière connue, l'étage intégrateur **210** peut comprendre une résistance d'entrée **211** reliée à l'entrée inverseuse **215** d'un amplificateur opérationnel **214** et un condensateur **212,** monté en parallèle entre l'entrée inverseuse **215** et la sortie **216** de l'amplificateur opérationnel **214.** Le condensateur **212** permet de réaliser l'intégration de la grandeur analogique d'entrée **V_{E}**.

L'étage de comparaison **220** comporte essentiellement deux comparateurs **221, 223,** dont les entrées non-inverseuses **222, 224** sont reliées respectivement aux tensions de référence **V**_{réf1} et **V**_{réf2}. La tension **V_{E}** intégrée par l'étage intégrateur **210** appliquée aux entrées inverseuses des comparateurs **221, 223** peut ainsi être comparée avec ces deux tensions de référence. Comme exposé précédemment, cette « comparaison » ou mesure de leur différence permet de définir les bornes supérieures **t₁** puis **t₂** des phases d'intégration de pente forte **102** et de pente faible **103.**

De plus, deux interrupteurs **232** et **233** sont montés en parallèle dans l'étage de commande de manière à sélectionner l'une ou l'autre des sources du courant **I** et **I/2B** de décharge du condensateur d'intégration **212.** On entend par interrupteur tout dispositif apte à basculer un circuit d'un état ouvert vers un état fermé et réciproquement. En pratique, des transistors peuvent constituer des interrupteurs. Ce faisant, l'étage de commande **230** détermine le gain de chacune des deux phases d'intégration **102** et **103,** gain qui est, de manière connue, inversement proportionnel à la capacité du condensateur intégrateur **212.**

Par ailleurs, lorsqu'il reçoit les signaux « d'annulation » émis par l'étage comparateur **220,** le circuit logique de contrôle **231** stoppe, en émettant un signal approprié sur ses sorties **234, 235** les compteurs d'impulsions **241, 242** délivrées par l'horloge de référence.

En fonctionnement, lorsque la différence entre la tension intégrée **V_{E}** et la tension de référence **V_{réf}** s'annule puis change de signe, le comparateur **221** émet un signal « d'annulation » vers un circuit logique de contrôle **231** de l'étage de commande **230.** Le circuit logique **231** pilote à son tour, de manière synchrone avec la fréquence fₕ de l'horloge **250,** deux compteurs **241** et **242.**

Pendant l'intervalle de temps **t₀-t₁**, le compteur **241** quantifie les bits de poids fort composant la grandeur analogique intégrée. Puis, pendant l'intervalle de temps **t₁-t₂**, le compteur **242** quantifie les bits de poids faible composant ladite grandeur analogique intégrée. Les bits de poids fort et de poids faible peuvent ensuite être additionnés de manière binaire au moyen d'un composant **260,** de façon à former un nombre binaire représentant la valeur de la grandeur analogique intégrée.

L'architecture électrique décrite ci-dessus en relation avec le convertisseur de la figure 1 présente ainsi les composants électroniques nécessaires à la mise en oeuvre de ce procédé de conversion de l'art antérieur. Ce faisant, lorsque ce type de convertisseur est mis en oeuvre au sein d'un détecteur matriciel possédant un nombre C de colonnes, il faut prévoir pour effectuer les conversions :
- C circuits intégrateurs,
- 2.C circuits comparateurs,
- et 2.C compteurs.

Or, plus le nombre de composants électroniques est élevé, plus leur consommation électrique totale est importante et plus les circuits s'échauffent. En outre, l'encombrement représenté par ces composants électroniques limite la finesse du pas de répétition entre deux colonnes de capteurs adjacentes. Par ailleurs, les rendements de fabrication sont d'autant plus faibles, et donc les coûts de fabrication sont évidemment d'autant plus importants qu'il y a de composants électroniques dans un convertisseur.

Ce procédé de conversion à deux pentes permet donc de réduire le temps de conversion d'une grandeur analogique, puisque le temps de conversion vaut :
**t_{conv1} = (2^{B} + 2^{M}) / fₕ,** où : **B** et **M** représentent respectivement les nombres de bits de poids fort et de poids faible, et **1 / fₕ** la durée d'une période d'échantillonnage ou d'une impulsion d'horloge **Tₕ**.

De son côté, le système de conversion simple pente nécessite un temps de conversion qui vaut :
**t_{conv2} = 2^{N} / fₕ**, où **N** représente le nombre **B + M** de bits total.

On vérifie facilement que **t_{conv1} < t_{conv2}**

Cependant, les procédés et les dispositifs de conversion fonctionnant avec deux pentes d'intégration achoppent actuellement sur plusieurs difficultés qui en limitent les performances de numérisation.

Tout d'abord, comme chaque colonne composant le détecteur matriciel possède son propre dispositif de conversion, l'encombrement de ce dernier limite la réduction du pas de répétition, donc la miniaturisation du détecteur. Or, un dispositif de conversion de l'art antérieur tel que celui illustré par la figure 2 nécessite l'implantation de deux comparateurs et de deux compteurs pour coder la grandeur analogique intégrée. L'implantation de ces doubles composants augmente donc l'encombrement du dispositif de conversion, par exemple, par rapport à l'encombrement d'un dispositif de conversion à simple rampe.

De plus, chaque comparateur **221** et **223** possède son propre seuil de basculement. Or, l'écart de tension entre les seuils de ces deux comparateurs est très faible, si bien qu'il est difficile de générer des tensions de référence **V**_{ref1} et **V**_{ref2} avec une précision suffisante pour numériser les bits de poids faible.

Ainsi par exemple, lorsque la première phase d'intégration **t₀**-**t₁** quantifie la grandeur analogique à intégrer au moyen d'un nombre à huit bits dits de poids fort, l'écart de tension entre les seuils des deux comparateurs vaut alors la dynamique totale du détecteur divisée par **2**⁸. La faiblesse de cet écart requiert donc une grande précision dans la génération des tensions de référence **V**_{ref1} et **V**_{ref2}, avec la condition **V**_{ref2}.> **V**_{ref1}.

En outre, si l'on tient compte de la tension de décalage des deux comparateurs (offset), on peut se retrouver dans le cas où, étant de signes opposées, la condition :
**V_{ref2} + V_{off2} > V_{ref1} + V_{off1}** n'est pas respectée.

Une autre difficulté provient du fait que le comparateur **223** destiné à numériser les bits de poids faible fonctionne sur une plage de tension restreinte, ce qui le rend très sensible aux bruits et aux perturbations électroniques survenant dans le circuit, en particulier lors de la commutation des interrupteurs **232** et **233.** La précision de quantification requise pour l'amplificateur opérationnel **223** doit être inférieure aux bits de poids le plus faible du convertisseur. L'erreur maximale tolérée doit être inférieure à la dynamique totale du détecteur divisée par 2^{N}, où N représente la résolution du dispositif de conversion. On constate que pour N élevé, cette erreur est très faible.

Par ailleurs, l'utilisation de deux amplificateurs opérationnels comparateurs **221** et **223** distincts pour les deux rampes **102** et **103** de pentes différentes, c'est-à-dire une pente lente et une pente rapide, conduit à une hystérésis différente pour chaque comparateur. Cette différence d'hystérésis entraîne alors une irrégularité ou une non-linéarité au niveau de la rupture de pente survenant à l'instant **t₁**.

En outre, le ratio entre les deux courants de décharge **I** et **I/2B** doit aussi être défini de manière suffisamment précise et non bruitée pour éviter une non-linéarité. En particulier dans le cas de la conversion au bout de chaque colonne, on rencontre le problème d'appariement entre sources de courant à transistors lorsque le nombre de colonnes est élevé.

Des solutions existent dans l'art antérieur pour compenser le décalage en tension (*offset*) d'un amplificateur monté en comparateur et pour corriger les écarts de gain entre pentes fortes et faibles. On peut par exemple utiliser un système d'autocalibration intégré au dispositif de conversion et comportant des composants électroniques supplémentaires tels qu'un potentiomètre.

Cependant, ces composants électroniques supplémentaires compliquent le montage et surtout augmentent la surface occupée par le dispositif de conversion. Or, un tel convertisseur doit pouvoir être logé au bout de chaque colonne, sur une petite surface, dont une dimension est définie par le pas de répétition des pixels, qui est typiquement compris entre 15 µm et 45 µm et que l'on cherche évidemment à réduire.

On peut également remarquer que le principe de correction en deux points, communément employée dans le domaine de l'imagerie infrarouge, permet de corriger le gain et de compenser le décalage en tension de chaque pixel. Toutefois, cette correction n'a aucun effet sur l'écart survenant à la rupture de pente d'un convertisseur à double rampe, tel que celui illustré à l'instant **t₁** sur la figure **1****,** c'est à dire que cette correction n'est d'aucun effet sur les erreurs de linéarité.

US 4 536 744 décrit un convertisseur à haute précision utilisant deux étapes de conversion. Dans une première étape, réalisé par un convertisseur à approximations successives, les bits de poids fort sont obtenus, puis dans une deuxième étape,employant un convertisseur du type double-rampe sur un signal résiduel, les bits de poids faible sont déterminés. La présente invention a pour objectif d'éviter les difficultés rencontrées par les procédés et dispositifs de conversion de l'art antérieur sans pour autant augmenter la surface occupée par un tel convertisseur.

### EXPOSE DE L'INVENTION

La présente invention concerne donc un procédé et un dispositif de conversion de grandeurs analogiques en signaux numériques qui permettent d'améliorer sensiblement les performances des procédés et dispositifs de l'art antérieur. La présente invention vise notamment à augmenter la précision de la conversion tout en diminuant le nombre de composants électroniques, leur consommation électrique, leur encombrement et le coût de fabrication d'un convertisseur analogique-numérique par rapport aux convertisseurs de l'art antérieur.

La présente invention a d'abord pour objet un procédé de conversion analogique numérique permettant une conversion précise et fidèle d'une grandeur analogique à intégrer. Un tel procédé permet de numériser une grandeur analogique issue d'un détecteur de rayonnements électromagnétiques, notamment de rayonnements infrarouges. Ce détecteur comprend une matrice de capteurs élémentaires juxtaposés, dont les interactions avec les rayonnements génèrent la grandeur analogique à intégrer. Selon l'invention, ce procédé comprend les étapes consistant, pour chaque ligne ou pour chaque colonne de la matrice :
- à réaliser une première phase d'intégration de la grandeur analogique sur un premier intervalle de temps au moyen d'un étage intégrateur ;
- à commander l'interruption de cette première phase d'intégration par l'intermédiaire d'un étage comparateur dont l'entrée inverseuse est reliée à la sortie de cet étage intégrateur et l'autre entrée à un circuit-référence délivrant une valeur de référence ;
- à convertir la grandeur analogique ainsi intégrée en une première valeur numérique par l'intermédiaire d'un compteur binaire connecté à la sortie de cet étage comparateur ;
- à mémoriser cette première valeur numérique sous forme d'un premier nombre binaire représentant les bits de poids fort ;
- à convertir cette première valeur numérique ainsi obtenue en un signal analogique de même nature que la grandeur analogique par l'intermédiaire d'un convertisseur numérique/analogique ;
- à soustraire ce signal analogique de la grandeur analogique à numériser ;
- à amplifier le signal résultant de la soustraction avec un gain représentant la première valeur numérique ;
- à réaliser une seconde phase d'intégration au moyen de l'étage intégrateur, de façon à produire une deuxième valeur numérique proportionnelle au signal analogique ainsi amplifié et formant un deuxième nombre binaire représentant les bits de poids faible ;
- à additionner les première et deuxième valeurs numériques de manière à former un nombre représentatif de la grandeur analogique à intégrer.

Ainsi, on décompose la numérisation de la grandeur analogique à intégrer en deux phases d'intégration (deux pentes), respectivement pour les bits de poids fort et les bits de poids faible, ce qui permet de numériser rapidement la grandeur analogique tout en n'ayant recours qu'à un seul comparateur. Au cours de la seconde phase d'intégration, on évalue le résidu à intégrer en ôtant la valeur des bits de poids fort, reconvertie en analogique, à la grandeur analogique à intégrer. De plus, le signal analogique représentant les bits de poids faible est amplifié avec un gain permettant d'augmenter la précision, c'est-à-dire de diminuer l'erreur maximale, de la seconde phase d'intégration.

En pratique, le gain peut valoir le nombre deux élevé à une puissance égale au nombre de bits de la première valeur numérique.

Ainsi, l'amplification du résidu de la grandeur analogique à intégrer permet donc de diminuer l'erreur maximale de la seconde phase d'intégration, donc de diminuer la contrainte pesant sur la précision de ce convertisseur numérique/analogique.

De manière pratique, la première valeur numérique peut être augmentée d'un bit de poids le plus faible avant l'étape de conversion, de manière à utiliser ce bit supplémentaire pour corriger le décalage en tension que présente l'étage comparateur.

Cette caractéristique du procédé objet de l'invention permet donc de compenser le décalage en tension (« *offset* ») que présente l'amplificateur opérationnel de l'étage comparateur.

Selon une forme de réalisation particulière de l'invention, l'étage intégrateur peut comprendre un condensateur et le procédé comprendre les étapes consistant :
- à charger ce condensateur avec la grandeur analogique à convertir ;
- à décharger sous un courant constant d'intensité forte ce condensateur lors de la première phase d'intégration ;
- à recharger ce condensateur avec une tension fonction de la différence entre la grandeur analogique à intégrer et le résultat de la première phase de conversion ;
- à décharger sous un courant constant d'intensité faible ce condensateur lors la seconde phase d'intégration.

Les adjectifs « forte » et « faible » indiquent une notion relative. En effet, en pratique, l'intensité du courant faible pourra être choisie égale au rapport de l'intensité du courant fort sur le nombre 2 élevé à une puissance égale au nombre de bits de la première valeur numérique. Par exemple, si cette première valeur numérique vaut 8 bits, l'intensité faible vaudra la 256^{ème} partie de l'intensité forte. De tels courants de décharge permettent de définir des pentes suffisantes pour obtenir une bonne précision au cours de chacune des phases d'intégration. De plus, comme les décharges sont réalisées à courant constant, on établit une relation directe entre tension et temps.

En pratique, la valeur de référence peut être déterminée en fonction de la plage de sensibilité du détecteur.

Cette caractéristique permet d'optimiser la moyenne des temps de conversion de l'ensemble des grandeurs analogiques pour la dynamique de détecteurs retenue.

Par ailleurs, l'invention concerne un dispositif pour numériser une grandeur analogique issue d'un détecteur de rayonnements électromagnétiques. Selon l'invention, ce dispositif comporte pour chaque colonne de la matrice :
- un étage intégrateur comprenant un amplificateur opérationnel, au moins un condensateur et un dispositif interrupteur, permettant d'initialiser ledit condesateur, électriquement commandable connectés en parallèle entre la sortie et l'entrée inverseuse de cet amplificateur opérationnel, cet étage intégrateur étant apte à intégrer la grandeur analogique lorsque le dispositif interrupteur est ouvert ;
- un étage comparateur comprenant un seul amplificateur opérationnel et dont une entrée est reliée à la sortie de l'étage intégrateur et l'autre entrée à un circuit-référence délivrant une valeur de référence ;
- un compteur binaire connecté à la sortie de cet étage comparateur et destiné à déterminer une première valeur numérique proportionnelle à la grandeur analogique intégrée ; toutefois, ce compteur binaire peut être déporté et être commun à toutes les colonnes, permettant un gain en termes de surface et de consommation électrique ;
- un circuit de contre-réaction numérique vers analogique de ce compteur et comprenant, en série :
   ▪ un convertisseur apte à convertir la première valeur numérique en un signal analogique de même nature que la grandeur analogique à numériser,
   ▪ des moyens pour soustraire ce signal analogique de la grandeur analogique à numériser ;
   ▪ ainsi que des moyens pour amplifier le signal résultant de la soustraction avec un gain dépendant du nombre de bits de la première valeur numérique,
- la sortie dudit circuit de contre-réaction numérique vers analogique étant reliée à l'entrée de l'étage intégrateur, de façon à ce que celui-ci produise une deuxième valeur numérique proportionnelle au signal analogique ainsi amplifié ;
- des moyens pour mémoriser ces première et deuxième valeurs numériques résultant des deux phases de conversion ;
- des moyens pour additionner ces première et deuxième valeurs numériques de manière à former un nombre représentatif de la grandeur analogique à intégrer.

En d'autres termes, le convertisseur analogique numérique de la présente invention comprend un seul amplificateur opérationnel intégrateur et un seul amplificateur opérationnel comparateur. De plus, il comprend un circuit de contre-réaction numérique/analogique permettant d'isoler, dans la grandeur analogique intégrée, les bits résiduels de poids forts, de convertir cette valeur en grandeur analogique, de la soustraire au signal analogique initial, puis d'amplifier ce signal faible afin d'augmenter la précision et la fidélité de la numérisation.

En pratique, le composant électronique de l'étage intégrateur est un condensateur. Un tel composant est en effet propre à réaliser convenablement l'intégration d'une grandeur analogique.

Selon une forme de réalisation pratique de l'invention, les moyens pour mémoriser peuvent comprendre une mémoire à circuit à verrouillage, mieux connue dans le domaine technique considéré sous l'expression anglo-saxonne « *latch* », reliée à la sortie du compteur binaire. Une telle mémoire présente l'avantage d'occuper une petite surface.

De manière pratique encore, le circuit de contre-réaction numérique/analogique est composé d'un système de décodage et d'une pluralité de capacités montées en parallèle et individuellement commutables au moyen d'interrupteurs pilotés par ledit système de décodage.

Un tel circuit de contre-réaction permet de réaliser les étapes menant à la seconde phase d'intégration tout en occupant un encombrement limité.

D'autre part, l'invention concerne également un détecteur de rayonnements électromagnétiques, notamment infrarouges, comprenant une matrice de capteurs élémentaires juxtaposés et un dispositif tel que précédemment exposé.

L'objet de l'invention réalise ainsi un détecteur complet apte à recevoir un rayonnement électromagnétique et puis à le convertir en signaux numériques.

En pratique, la matrice de ce détecteur peut présenter une seule ligne ou une seule colonne.

D'autre part, les capteurs élémentaires peuvent être des bolomètres. Cela permet de réaliser des images thermiques d'objets à l'aide d'un instrument opérant à température ambiante.

### BREVE DESCRIPTION DES DESSINS

L'invention et ses avantages ressortiront aussi de la description des modes de réalisation particuliers illustrés par les figures, données à titre exemplatif et non limitatif, parmi lesquelles :
La figure 1 est une représentation schématique d'un graphique tension/temps, illustrant un procédé de conversion de l'art antérieur. Cette figure a déjà été décrite en relation avec l'art antérieur.
La figure 2 est une représentation schématique d'un dispositif de conversion analogique numérique conforme à une forme de réalisation de l'art antérieur. Cette figure a déjà été décrite en relation avec l'art antérieur.
La figure 3 est une représentation schématique d'un graphique illustrant une forme de réalisation du procédé - objet de la présente invention.
La figure 4 est une représentation schématique d'un dispositif de numérisation conforme à une forme de réalisation de l'invention.
La figure 5 est une représentation schématique montrant des détails du circuit de contre-réaction du dispositif de numérisation illustré par la figure 4.

### MODES DE REALISATION DE L'INVENTION

On a représenté au sein de la figure 3 un chronogramme montrant l'intégration d'une tension au cours du temps. L'axe des abscisses représente donc le temps et l'axe des ordonnées la tension. Sur la figure 3, la courbe **301** présente donc l'intégration d'une tension d'entrée **V_{E}**, qui débute par une première phase d'intégration selon une rampe linéaire **302** et se termine par une seconde phase d'intégration suivant une rampe linéaire **303.**

La grandeur analogique intégrée est ici une tension. Cette grandeur analogique pourrait cependant être constituée par une autre grandeur électrique représentative des propriétés manifestées par les capteurs élémentaires du détecteur lors de leur interaction avec les rayonnements incidents. Il pourrait ainsi s'agir de la quantité de charges électriques par exemple.

Les instants **t₁** et **t₂** sont séparés par un palier **304** au cours duquel est effectué la phase dite de réinitialisation. Cette phase de réinitialisation permet de convertir la première valeur numérique représentant les bits de poids fort en un signal analogique qui est ensuite ôté de la grandeur analogique à intégrer **V_{E}**, puis amplifiée avant la seconde phase d'intégration. Cette amplification est illustrée par le segment de droite vertical situé au niveau de l'instant **t₂.** Comme le montre la figure 3, le gain de cette amplification vaut ici le nombre **2** élevé à la puissance **B, B** correspondant au nombre de bits de points fort ayant servi à coder la première partie de la grandeur analogique intégrée **V_{S}.**

La première phase d'intégration débute à l'instant **t₀** et se termine à l'instant **t₁,** de manière synchrone avec une horloge de référence (non représentée), après l'annulation puis le changement de signe de la différence entre la tension intégrée **V_{S} = V_{E}** et une valeur de référence **V_{réf}**.

La seconde phase d'intégration débute à l'instant **t₂** et se termine à l'instant **t₃** après l'annulation puis le changement de signe de la différence entre la tension intégrée **V_{S}** = **2^{B}(V_{E} - V_{DAC})** et la valeur de référence **V_{réf}.** Afin de faciliter la compréhension du graphique, le niveau de la valeur de référence **V_{réf}** est matérialisé par une ligne pointillée horizontale.

Dans le procédé de l'invention, les deux intervalles **t₀ - t₁** et **t₂ - t₃** sur la base desquels sont réalisées les deux phases d'intégration d'une grandeur analogique, représentée ici par une tension, sont séparés par une temporisation **304** au cours de laquelle aucune intégration n'est réalisée. Cette temporisation est matérialisée par un palier horizontal (à tension intégrée constante), symbolisant l'absence d'intégration. Conformément à l'invention et comme exposé par la suite, cette temporisation peut être mise à profit pour effectuer des opérations de réinitialisation au niveau des différents étages du dispositif de numérisation de la présente invention.

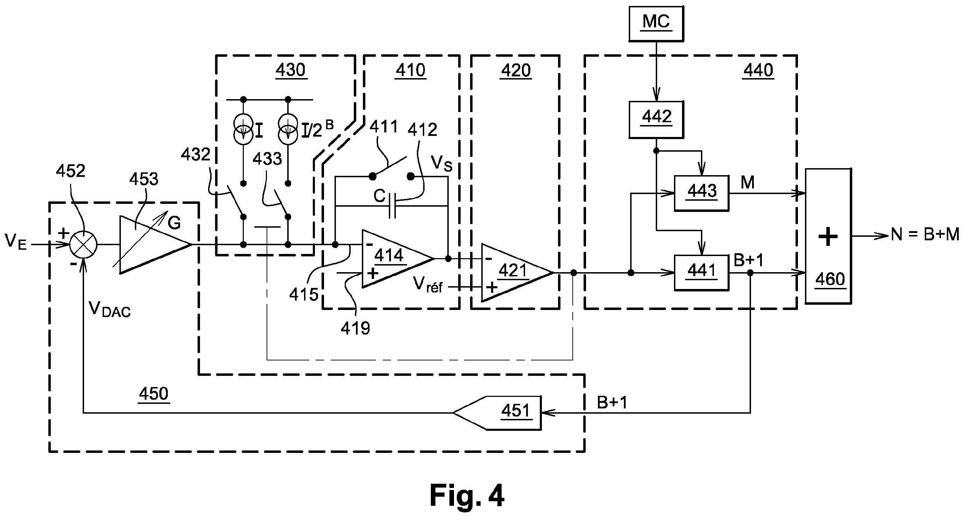

La figure 4 illustre un tel dispositif de conversion comportant, conformément à l'invention, un étage intégrateur **410,** un étage différentiel ou comparateur **420,** un étage de commande du courant de décharge **430** et un étage de comptage et mémorisation **440.** Ces différents étages remplissent peu ou prou les mêmes fonctions que les étages correspondants des convertisseurs de l'art antérieur décrit en relation avec la figure 2.

De plus, le dispositif de numérisation de l'invention comporte un circuit de contre-réaction numérique/analogique **450.** Ce circuit de contre-réaction **450** est constitué d'une branche montée en contre-réaction entre la sortie de mémorisation **441** du compteur **442** et l'entrée **415** de l'étage intégrateur **410.** Comme exposé précédemment, le circuit de contre-réaction **450** comporte un convertisseur numérique/analogique **451** destiné à convertir la première valeur numérique obtenue après la première phase d'intégration **302** en un signal analogique représentant la part de la grandeur analogique intégrée correspondant aux bits de poids fort **(B** + **1).**

Le circuit de contre-réaction **450** comporte en outre des moyens **452** pour soustraire le signal analogique ainsi converti à la grandeur analogique à intégrer **V_{E}**. Des moyens d'amplification **453** sont ensuite prévus dans le circuit de contre-réaction pour multiplier le signal résultant de la soustraction [**V_{E} - V_{DAC}**] par un gain valant ici **2^{B}**, soit le nombre **2** élevé à la puissance **B.** Comme exposé précédemment cette amplification est matérialisée sur le diagramme de la figure 3 par le segment rectiligne vertical appliqué l'instant **t₂**. Préalablement, la conversion numérique/analogique par le convertisseur **451** et la soustraction par les moyens **452** se sont déroulés pendant la durée **304** au cours de laquelle aucune intégration n'est réalisée. On peut noter qu'à l'instant **t₀**, la tension **V_{E}** est directement appliquée sur l'entrée **415** de l'étage intégrateur **410,** c'est à dire que grâce à un jeu d'interrupteurs (non représentés), les circuits **452** et **453** sont inopérants et n'effectuent respectivement ni soustraction ni gain.

Le palier **304** a une durée minimale, prévue dans le dispositif de gestion des horloges. Cependant, sa durée est variable dans la mesure où elle dépend de la valeur de **V_{E}**. En fait, les instants **t₀** et **t₂** sont fixes et connus ; en revanche, les instants **t₁** et **t₃** dépendent de **V_{E}**.

L'étage intégrateur **410** est destiné à intégrer la tension d'entrée **V_{E}** provenant des capteurs élémentaires lors de la première phase d'intégration, et à intégrer la tension résiduelle **2^{B} . (V_{E}.**- **V_{DAC})** lors de la deuxième phase d'intégration. L'étage différentiel **420** permet de comparer la tension intégrée **V_{S}** avec la valeur de référence **V_{réf}** de façon à déterminer l'arrêt des première et seconde phases d'intégration. L'étage de commande du courant de décharge **430** sert à piloter l'étage intégrateur **410** de manière à réaliser successivement une pente d'intégration forte **302,** et une pente d'intégration faible **303.** Enfin, l'étage de comptage mémorisation **440** permet de mémoriser le nombre d'impulsions qu'émet l'horloge de référence **MC** pendant chacune des phases d'intégration et, partant, de quantifier ou « numériser » la tension intégrée **V_{E}**. Les instants **t₀** et **t₂**, qui déterminent le début des comptages, sont identiques pour tous les convertisseurs analogique/numérique des colonnes. Ainsi, le compteur **442** peut être commun à tous les convertisseurs analogique/numérique, et déclenché à **t₀**, puis **t₂**.

Dans chaque étage du convertisseur analogique/numérique, les dispositifs de mémorisation **441, 443** permettent de capturer à la volée, respectivement les valeurs à **t₁** et à **t₃**, qui peuvent ainsi être différentes pour chacun des convertisseurs analogique/numérique des colonnes. Le compteur commun **442** effectue pour chaque intégration, un comptage à **t₁ₘₐₓ** puis **t₃ₘₐₓ**, afin de couvrir toute la dynamique.

L'étage intégrateur **410** du convertisseur de l'invention est donc semblable à l'étage intégrateur **210** des convertisseurs de l'art antérieur. Ainsi, les amplificateurs opérationnels **214** et **414** sont reliés à une référence électrique par leur entrée non inverseuse, respectivement **219** et **419.** Cette référence est propre à la dynamique et à la technologie du circuit de lecture ; elle n'influe pas sur le système de conversion.

En revanche, contrairement à l'étage comparateur illustré sur la figure 2, l'étage différentiel du convertisseur de la figure 4 ne possède qu'un seul montage comparateur, lequel est équipé d'un amplificateur opérationnel **421.** L'entrée inverseuse de l'amplificateur opérationnel **421** reçoit la tension intégrée **V_{S}** et son entrée non-inverseuse est reliée à un circuit délivrant la tension de référence **V_{réf}**. Le mode de génération de cette tension de référence étant réalisé conformément à l'état antérieur de la technique, il n'est pas détaillé dans la présente description.

Par conséquent, l'étage comparateur **420** occupe un espace inférieur à celui occupé par l'étage comparateur de l'art antérieur **220.** De plus, il consomme une puissance électrique sensiblement plus faible. Partant, l'échauffement qui se produit dans ces circuits est sensiblement inférieur à l'échauffement qui se produit dans les circuits de l'étage intégrateur **220.** En outre, les coûts de matière et de fabrication de l'étage différentiel **420** sont inférieurs à ceux de l'étage **220.**

L'étage de commande du courant de décharge **430** agit par l'intermédiaire des interrupteurs **432** et **433,** sélectionnant ainsi l'une ou l'autre des sources de courant **I** et **I/2^{B}** déchargeant un condensateur C monté entre la sortie et l'entrée inverseuse de l'étage intégrateur **410.** Ce faisant, l'étage de commande **430** détermine le gain de chacune des deux phases d'intégration **302** et **303,** gain qui est, de manière connue, inversement proportionnel à la capacité du condensateur intégrateur **C.**

L'étage de commande de décharge peut cependant être réalisé par une rampe en tension associée à une capacité, plutôt que par un dispositif en courant. Ces deux techniques sont parfaitement connues de l'homme du métier, et présentent chacune leurs propres avantages et inconvénients. Elles ne modifient pas le principe de l'invention. Le principe en courant est retenu ici pour la clarté de l'exposé.

Par commodité, pour distinguer les liaisons électriques directement impliquées dans l'intégration de la liaison de pilotage des interrupteurs **432** et **433** émis par l'étage de commande **430,** ces dernières ont été tracées en traits mixtes. En réalité, il n'y a évidemment pas de discontinuité des liaisons **432** et **433.**

L'étage de comptage **440** comporte deux éléments mémoire **441** et **443.** Le compteur **442,** qui peut être commun à plusieurs convertisseurs analogique/numérique, est lui-même alimenté en impulsions par une horloge de référence **MC.** La sortie du compteur **442** est reliée aux mémoires **441, 443** de façon à y écrire sa valeur courante. Les mémoires **441, 443** peuvent être une mémoire à circuit de verrouillage, « *latch* ». Elles sont aptes à mémoriser respectivement un nombre de **B + 1** bits correspondant aux bits de poids fort, et un nombre **M** bits correspondant aux bits de poids faible.

En fonctionnement, le condensateur **C** est chargé à la tension **V_{E}**, puis déchargé sous un courant **I**. L'étage intégrateur **410** réalise ainsi la première phase d'intégration **302** de la tension d'entrée **V_{E}**, jusqu'à ce que la différence mesurée par l'étage comparateur **420** entre la tension intégrée **V_{S}** et la tension de référence **V_{réf}** ait changé de signe. Cette différence est mesurée par l'amplificateur opérationnel **421,** lequel délivre simultanément à l'étage de commande de courant de décharge **430** et à l'étage de comptage **440** un signal marquant la fin de cette première phase d'intégration **302.**

A la fin de cette première phase d'intégration, l'étage comparateur **420** émet un signal d'arrêt vers l'étage de comptage **440** pour qu'il mémorise la valeur numérique intégrée sous la forme d'un nombre binaire correspondant aux bits de poids forts. Le compteur **442** a donc pour fonction de « chronométrer » les phases d'intégration. Pour cela, il compte par incrémentation les impulsions délivrées par l'horloge de référence **MC,** puis transmet le nombre ainsi incrémenté à la mémoire **441** de l'étage de comptage **440** par l'intermédiaire d'un bus classique pour ce genre de structure.

Lorsque la valeur courante du compteur **442** a été enregistrée dans la mémoire **441,** le compteur **442** poursuit son comptage jusqu'à **2^{B+1}** bits ; il doit ensuite être remis à zéro à partir de l'instant **t₂**.pour comptabiliser la durée de la seconde phase d'intégration, celle correspondant aux bits de poids faible. La seconde phase d'intégration est à nouveau réalisée par l'étage intégrateur **410** jusqu'à la date où la tension intégrée **V_{S}** atteint ou, en pratique, dépasse la valeur de référence **V_{réf}**.

Sur la figure 3, cette date est notée **t₃**. Elle correspond au moment où la valeur courante du compteur **442** est enregistrée dans la mémoire **443** des bits de poids faible.

Conformément à l'invention, durant la phase de réinitialisation, le condensateur **C** est chargé sous une tension **2^{B}.[V_{E}-V_{DAC}]**. Après cette réinitialisation, l'étage de contrôle **430** commute les interrupteurs **432** et **433** de manière à activer et/ou désactiver les sources de courant **I** et **I/2^{B}**. Cette commutation permet à l'étage intégrateur **410** de décharger le condensateur C sous un courant d'intensité faible **I/2^{B}** lors de la seconde phase d'intégration **303.** Cela permet de réaliser une seconde phase d'intégration relativement lente, donc précise. On obtient ainsi une précision élevée pour les bits de poids faible.

De plus, l'amplification par le gain **2^{B}** du résidu à intégrer **[V_{E}-V_{DAC}]** permet donc de diminuer la contrainte pesant sur la précision du convertisseur numérique/analogique **451.** En effet, l'erreur maximale lors de la deuxième intégration vaut alors la dynamique totale divisée par le gain **2^{N-B}**, alors qu'elle vaudrait la dynamique totale divisée par le gain **2^{N}** pour un dispositif de conversion de l'art antérieur, **N** représentant le nombre de bits nécessaire au codage de la tension maximale intégrable par le dispositif de conversion, ce qui correspond en fait à la dynamique totale.

Cet avantage permet donc d'utiliser un convertisseur numérique/analogique **451** tel que représenté sur la figure 5. Un tel convertisseur comprend un système à capacités **Cᵢ** commutées et un système de décodage des interrupteurs. L'appariement des capacités **Cᵢ** détermine la précision du gain et la tension de sortie **V_{DAC}** du convertisseur. Cette tension **V_{DAC}** est fonction de **V_{R+}** et de **V_{R-}**.

Ainsi, les bits de poids fort **B** de la première phase d'intégration commandent par décodage les interrupteurs de sélection des capacités, qui vont être connectées, suivant la valeur de **B,** à **V_{E}** et/ou **V**_{**R**+} et/ou **V**_{**R**-} pendant la phase **304.**

Ensuite, l'interrupteur **413** est fermé à l'instant **t₂**, et le rapport des différentes capacités **Cᵢ** du dispositif illustré à la figure 5 avec la capacité **412** de l'intégrateur, permet de réaliser une triple opération symbolisée dans le circuit de contre-réaction **450 :**
▪ conversion numérique/analogique, donc génération de **V_{DAC}** (par la sélection de **V_{R+}/V_{R-}**.avec les capacités associées au décodage et aux interrupteurs) ;
▪ soustraction **V_{E} - V_{DAC}** par l'association des capacités ;
▪ gain **2^{B}** par le rapport des capacités **Cᵢ** de la figure 5 avec la capacité **C 412** de l'intégrateur à l'instant **t₂**.

Ainsi, un seul amplificateur opérationnel **414** est utilisé pour réaliser les fonctions de la branche de contre-réaction **450** et de l'étage intégrateur **410.**

L'appariement des capacités **Cᵢ** est d'autant plus difficile à obtenir que la surface d'implantation des composants électroniques est restreinte (ici le pas de répétition entre pixels). Par conséquent, la diminution de la contrainte de précision du convertisseur par le gain **2^{B}** réduit d'autant cette contrainte d'implantation. Le dimensionnement du convertisseur résulte d'un compromis entre le nombre de bits **B** définissant le gain et la surface occupée par les capacités **Cᵢ**. Il est également tenu compte de l'équilibre existant entre la consommation du convertisseur numérique/analogique **451** et la bande passante de l'amplificateur **414** qui est fonction du gain **G** appliqué.

La seconde phase d'intégration présente une pente **303,** dont le coefficient directeur est inférieur à la pente que présente la première phase d'intégration **302.** En effet, le signal analogique transmis par le circuit de contre-réaction est amplifié par le gain **2^{B}**, tandis que le courant de décharge du condensateur **C** de l'étage intégrateur **410** vaut **I/2^{B}**, c'est-à-dire le courant de décharge **I** de la première intégration **302** divisé par **2^{B}**.

Comme pour le convertisseur numérique/analogique **451,** la précision requise de l'étage comparateur **420** peut être réduite par le gain **2^{B}**, qui amplifie la pente **303** de la seconde phase d'intégration. Au contraire, dans les dispositifs de conversion de l'art antérieur, la seconde pente **103** est beaucoup plus faible et requiert une numérisation plus précise.

Pour les deux phases, avantageusement, on pratique une correction du décalage en tension (« *offset* ») en déclenchant le compteur **442** une demi-période d'horloge après le début de l'intégration. Ce décalage lors du déclenchement du compteur **442** est ensuite compensé lors de la somme du dernier bit de poids fort **B + 1** avec le premier bit de poids faible **M.** Cette correction par un digit du décalage en tension consiste donc à ajouter systématiquement un décalage numérique pendant la première intégration. En effet, l'offset est créé par le retard d'une demi-période opéré lors du déclenchement du compteur **442.** Ce principe est connu de l'homme du métier, notamment dans les convertisseurs de type « *flash pipeline* ».

A la fin de la seconde phase d'intégration, l'étage comparateur **420** commande la mémorisation d'une deuxième valeur numérique **M** (codée sur M bits) dans la mémoire **443,** correspondant aux bits de poids faible, c'est-à-dire à la partie résiduelle de la tension intégrée. Les moyens **460** réalisent alors une addition (binaire) des valeurs numériques **M** et **B + 1** issues des deux phases d'intégration, réalisant ainsi la correction du décalage en tension, la valeur **B + 1** ayant été mémorisée dans la mémoire **441.** Le nombre résultant **N = B + M** codant cette somme comprend un nombre de bits **N** apte à coder la tension maximale **V_{E}** à intégrer.

Le compteur **442** est donc dimensionné pour quantifier les **M** bits de poids faible, qui sont plus nombreux que les **B** bits de poids fort (durée d'intégration plus longue), ce qui est résumé par l'équation **M > B** + **1**. Un tel compteur **442** est donc apte à quantifier les **B** bits de poids fort lors de la première phase d'intégration, puis, après sa réinitialisation (remise à zéro), les **M** bits de poids faible, lors de la seconde phase d'intégration.

Ainsi, la structure de l'étage comparateur **420** avec un seul amplificateur opérationnel comparateur **421** permet une économie en termes de coût de fabrication, de consommation électrique et d'espace nécessaire à l'implantation du dispositif de conversion analogique/numérique.

En outre, l'utilisation d'un seul amplificateur opérationnel **421** procure un autre avantage par rapport aux détecteurs de l'art antérieur. Elle permet en effet de réaliser la fonction de comparaison en annulant le décalage en tension ou tension d'erreur différentielle (« *offset* ») inhérente à l'utilisation d'un amplificateur opérationnel.

En effet, en pratique, il est connu que la sortie d'un amplificateur opérationnel comparateur de tension bascule quand la différence de tension entre ces deux entrées correspond à une certaine tension de décalage. Dans le cas idéal, cette tension de décalage est nulle. En pratique, pour des raisons technologiques, il est difficile de contrôler cette tension de décalage qui n'est par conséquent pas nulle.

Dans le cas d'un convertisseur de l'art antérieur, l'erreur différentielle vaut la différence entre les tensions de décalage des deux amplificateurs opérationnels **221** et **223.** Elle conduit de fait à un système coûteux d'annulation d'offset, afin que le comparateur de la deuxième pente ne déclenche pas avant celui de la première pente. Au contraire, dans le cas du convertisseur - objet de l'invention, la tension de décalage est la même pour les deux phases d'intégration, puisque c'est le même amplificateur opérationnel **421** qui mesure la différence. Par conséquent, le décalage en tension lors de la seconde phase d'intégration compense celui de la première phase d'intégration et l'erreur différentielle s'annule. Le convertisseur-objet de l'invention est donc plus précis que les convertisseurs de l'art antérieur.

D'autres formes de réalisation du procédé ou du dispositif de l'invention sont possibles sans pour autant sortir du cadre de cette invention. En particulier, le principe de conversion de l'invention peut être étendu sans difficulté majeure à des convertisseurs du type à multiples rampes et multiples pentes.

Cette invention trouve application notamment dans le domaine des détecteurs matriciels, dont font partie les détecteurs à une seule dimension (« barrette »), quels que soient le rayonnement électromagnétique incident et le type de détecteurs mis en oeuvre. Cette invention trouve plus particulièrement application dans le domaine des détecteurs matriciels, c'est à dire bi-dimensionnels, de rayonnement infrarouge.

## Revendications

1. Procédé pour numériser une grandeur analogique (V_{E}) issue d'un détecteur de rayonnements électromagnétiques, notamment de rayonnements infrarouges, ledit détecteur comprenant une matrice de capteurs élémentaires juxtaposés, dont les interactions avec lesdits rayonnements génèrent ladite grandeur analogique (V_{E}), procédé comprenant les étapes consistant, pour chaque ligne ou pour chaque colonne de ladite matrice :
- à réaliser une première phase d'intégration (302) de ladite grandeur analogique sur un premier intervalle de temps au moyen d'un étage intégrateur (410) ;
- à commander l'interruption de ladite première phase d'intégration (302) par l'intermédiaire d'un étage comparateur (420) dont une entrée est reliée à la sortie dudit étage intégrateur (410) et l'autre entrée à un circuit-référence délivrant une valeur de référence (V_{réf});
- à convertir la grandeur analogique ainsi intégrée (V_{S}) en une première valeur numérique (B) par l'intermédiaire d'un compteur binaire (442) et d'un élément mémoire (441) connecté à la sortie dudit étage comparateur (420) ;
- à mémoriser ladite première valeur numérique (B) sous forme d'un premier nombre binaire représentant les bits de poids fort ;
ledit procédé étant ***caractérisé* en ce qu'**il comprend en outre les étapes consistant, pour chaque ligne ou pour chaque colonne de ladite matrice :
- à convertir ladite première valeur numérique (B) ainsi obtenue en un signal analogique (V_{DAC}) de même nature que la grandeur analogique à numériser (V_{E}) par l'intermédiaire d'un convertisseur numérique/ analogique (451) ;
- à soustraire ledit signal analogique (V_{DAC}) à ladite grandeur analogique à numériser (V_{E}) ;
- à amplifier le signal (V_{E} - V_{DAC}) résultant de ladite soustraction avec un gain représentant ladite première valeur numérique (B) ;
- à réaliser une seconde phase d'intégration (303) au moyen dudit étage intégrateur (410), de façon à produire une deuxième valeur numérique (M) proportionnelle au signal analogique ainsi amplifié 2^{B}.(V_{E} - V_{DAC}) et formant un deuxième nombre binaire représentant les bits de poids faible ;
- à additionner lesdites première (B) et deuxième (M) valeurs numériques de manière à former un nombre (N) représentatif de ladite grandeur analogique à intégrer (V_{E}).

2. Procédé selon la revendication 1, ***caractérisé* en ce que** ledit gain (2^{B}) vaut le nombre deux élevé à la puissance de ladite première valeur numérique.

3. Procédé selon la revendication 2, ***caractérisé* en ce que** ladite première valeur numérique (B) est augmentée d'une unité avant ladite étape de conversion, de manière à corriger le décalage en tension que présente l'étage comparateur (420).

4. Procédé selon l'une des revendications précédentes, ledit étage intégrateur (410) comprenant un condensateur (C), ledit procédé étant ***caractérisé*** en qu'il comprend les étapes consistant :
- à charger ledit condensateur (C) avec la grandeur analogique à convertir ;
- à décharger sous un courant constant d'intensité forte (I) ledit condensateur (C) lors de la première phase d'intégration (302) ;
- à recharger ledit condensateur (C) avec une tension (V_{E} - V_{DAC}) fonction de la différence entre la grandeur analogique à intégrer (V_{E}) et le résultat de la première phase de conversion ;
- à décharger sous un courant constant d'intensité faible (I/2^{B}) ledit condensateur (C) lors la seconde phase d'intégration (303).

5. Procédé selon l'une des revendications précédentes, ***caractérisé* en ce que** la valeur de référence (V_{réf}) est déterminée en fonction de la plage de sensibilité du détecteur.

6. Dispositif pour numériser une grandeur analogique (V_{E}) issue d'un détecteur de rayonnements électromagnétiques, notamment de rayonnements infrarouges, ledit détecteur comprenant une matrice de capteurs élémentaires juxtaposés, dont les interactions avec lesdits rayonnements génèrent ladite grandeur analogique, ledit dispositif comportant, pour chaque ligne ou pour chaque colonne de ladite matrice :
- un étage intégrateur (410) comprenant un amplificateur opérationnel (414), au moins un condensateur (C) et un dispositif interrupteur (411) électriquement commandable connectés en parallèle entre la sortie et l'entrée inverseuse (-) dudit amplificateur opérationnel (414), ledit étage intégrateur (410) étant apte à intégrer ladite grandeur analogique (V_{E}) lorsque ledit dispositif interrupteur (411) est ouvert ;
- un étage comparateur (420) comprenant un seul amplificateur opérationnel (421), et dont l'entrée inverseuse (-) est reliée à la sortie dudit étage intégrateur et l'autre entrée à un circuit-référence délivrant une valeur de référence (V_{réf});
- un compteur binaire (442) connecté à deux éléments mémoires (441, 443) pilotés par la sortie dudit étage comparateur (420) et destiné à déterminer une première valeur numérique (B) proportionnelle à ladite grandeur analogique intégrée (V_{S});
- des moyens pour mémoriser ladite première valeur numérique (B) ;
- un circuit de contre-réaction (450), dont l'entrée est reliée à la sortie dudit élément mémoire (441) et comprenant :
▪ un convertisseur (451) apte à convertir ladite première valeur numérique (B) en un signal analogique (V_{DAC}) de même nature que ladite grandeur analogique (V_{E}),
▪ des moyens (452) pour soustraire ledit signal analogique (V_{DAC}) de ladite grandeur analogique (V_{E}),
▪ ainsi que des moyens (453) pour amplifier le signal (V_{E} - V_{DAC}) résultant de ladite soustraction avec un gain (2^{B}) dépendant du nombre B de bits de ladite première valeur numérique,
- la sortie dudit circuit de contre-réaction (450) étant reliée à l'entrée (415) dudit étage intégrateur (410), de façon à ce que ce dernier produise une deuxième valeur numérique (M) proportionnelle au signal analogique ainsi amplifié (2^{B}.[V_{E} - V_{DAC}]);
- des moyens (460) pour additionner lesdites première (B) et deuxième (M) valeurs numériques de manière à former un nombre (N) représentatif de ladite grandeur analogique à intégrer (V_{E}).

7. Dispositif selon la revendication 6, ***caractérisé* en ce que** le compteur binaire (442) est déporté et commun à plusieurs convertisseurs analogique/numérique disposés sur chaque colonne.

8. Dispositif selon l'une des revendications 6 à 7, ***caractérisé* en ce que** les moyens pour mémoriser comprennent deux mémoires à circuit à verrouillage (441, 443) reliées à la sortie du compteur binaire (442).

9. Dispositif selon l'une des revendications 6 à 8, ***caractérisé* en ce que** ledit circuit de contre-réaction (450) comprend un système de décodage, apte à réaliser la fonction de conversion numérique/analogique, et une pluralité de capacités montées en parallèle et individuellement commutables au moyen d'interrupteurs.

10. Détecteur de rayonnements électromagnétiques, notamment infrarouges, comprenant une matrice de capteurs élémentaires juxtaposés, ***caractérisé* en ce qu'**il comporte un dispositif selon l'une des revendications 6 à 9.

11. Détecteur de rayonnements électromagnétiques selon la revendication 10, ***caractérisé* en ce que** la matrice présente une seule ligne ou une seule colonne.

12. Détecteur de rayonnements électromagnétiques selon l'une des revendications 10 à 11, ***caractérisé* en ce que** les capteurs élémentaires sont des bolomètres.

## Patentansprüche

1. Verfahren zur Digitalisierung einer analogen Größe (V_{E}), die von einem elektromagnetische Strahlungsdetektor, insbesondere Infrarot-Strahlung, geliefert wird, wobei dieser Detektor eine Matrix nebeneinander gestellter, elementarer Fühler umfasst, deren Interaktionen mit diesen Strahlungen diese analoge Größe (V_{E}) erzeugen, Verfahren, das die Etappen umfasst, die für jede Reihe oder für jede Spalte der genannten Matrix bestehen aus:
- Ausführung einer ersten Integrationsphase (302) dieser analogen Größe in einem ersten Zeitintervall mittels einer Integrationsstufe (410);
- Steuerung der Unterbrechung der Integrationsphase (302) mittels einer Komparatorstufe (420), bei der ein Eingang mit dem Ausgang dieser Integrationstufe (410) verbunden ist und der andere Eingang mit einem Referenzschaltkreis (410) verbunden ist, der einen Referenzwert (V_{Ref}) liefert;
- die Umwandlung der so integrierten analogen Größe (V_{S}) in einen ersten digitalen Wert (B) mittels eines Binärzählers (442) und eines Speicherelementes (441), der mit dem Ausgang dieser Komparatorstufe (420) verbunden ist;
- die Speicherung dieses ersten digitalen Wertes (B) in Form einer ersten Binärzahl, die die höchstwertigsten Bits repräsentiert;
dieses Verfahren ist ***dadurch gekennzeichnet, dass*** es außerdem die Etappen umfasst, die für jede Reihe oder für jede Spalte der genannten Matrix bestehen aus:
- der Umwandlung des genannten, so erhaltenen ersten digitalen Wertes (B) in ein analoges Signal (V_{DAC}) derselben Art wie die zu digitalisierende analoge Größe (V_{E}) mittels eines Digital-/ Analog - Wandlers (451);
- der Subtraktion dieses analogen Signals (V_{DAC}) von dieser zu digitalisierenden analogen Größe (V_{E}) ;
- Verstärkung des Signals (V_{E} - V_{DAC}), das sich aus dieser Subtraktion ergibt, durch einen Zuwachs, der diesen ersten digitalen Wert (B) repräsentiert;
- Durchführung einer zweiten Integrationsphase (303) mittels dieser Integrationsstufe (410), um einen zweiten digitalen Wert (M), proportional zum so verstärkten Signal 2^{B}.(V_{E} - V_{DAC}) zu erzeugen und eine zweite Binärzahl zu bilden, die die niederwertigsten Bits darstellt,
- Addition des ersten (B) und zweiten (M) digitalen Werte um eine Zahl (N) zu bilden, die für die zu integrierende analoge Größe (V_{E}) representativ ist.

2. Verfahren gemäß Anspruch 1, ***dadurch gekennzeichnet, dass*** dieser Zuwachs (2^{B}) den Wert zwei hoch der Wertigkeit des ersten digitale Wertes hat.

3. Verfahren gemäß Anspruch 1, ***dadurch gekennzeichnet, dass*** dieser erste digitale Wert (B) um eine Einheit vor jeder Umwandlungsetappe erhöht wird, so dass die Spannungsverschiebung korrigiert wird, die die Komparatorstufe (420) darstellt.

4. Verfahren gemäß einem der vorhergehenden Ansprüche, wobei diese Integrationsstufe (410) einen Kondensator (C) umfasst, wobei dieses Verfahren ***dadurch gekennzeichnet* ist, *dass*** es die Etappen umfasst, die daraus bestehen:
- Ladung des genannten Kondensators (C) mit der umzuwandelnden analogen Größe;
- Entladung dieses Kondensators (C) unter einem konstanten Strom hoher Stärke (I) während der ersten Integrationsphase (302);
- erneuter Ladung dieses Kondensators (C) mit einer Spannung (V_{E} - V_{DAC}), die Funktion der Differenz zwischen der zu integrierenden analogen Größe (V_{E}) und dem Ergebnis der ersten Integrationsphase ist;
- Entladung unter einem konstanten Strom geringer Stärke (I/2^{B}) (I) dieses Kondensators (C) während der zweiten Integrationsphase (303).

5. Verfahren gemäß einem der vorhergehenden Ansprüche, ***dadurch gekennzeichnet, dass*** der Referenzwert (V_{Ref}) in Abhängigkeit vom Empfindlichkeitsbereich des Detektors bestimmt wird.

6. Vorrichtung zur Digitalisierung einer analogen Größe (V_{E}), die von einem elektromagnetische Strahlungsdetektor, insbesondere Infrarot-Strahlung, geliefert wird, wobei dieser Detektor eine Matrix nebeneinander gestellter elementarer Fühler umfasst, deren Interaktionen mit diesen Strahlungen diese analoge Größe (V_{E}) erzeugen, wobei diese Vorrichtung für jede Reihe oder für jeder Spalte der genannten Matrix enthält:
- eine Integrationsstufe (410) mit einem Operationsverstärker (414), mindestens einem Kondensator (C) und einer elektrisch steuerbaren Schaltvorrichtung (411), die parallel zwischen dem Ausgang und dem invertierenden Eingang (-) dieses Operationsverstärker (414) geschaltet sind, wobei diese Integrationsstufe (410) in der Lage ist, die genannte analoge Größe (V_{E}) zu integrieren, wenn diese Schaltvorrichtung (411) geöffnet ist;
- eine Komparatorstufe (420) mit einem einzigen Operationsverstärker (421), dessen invertierender Eingang (-) mit dem Ausgang dieser Integrationsstufe verbunden ist und der andere Eingang mit einem Referenzschaltkreis verbunden ist, der einen Referenzwert (V_{Ref}) liefert;
- einen Binärzähler (442), der mit zwei Speicherelementen (441, 443) verbunden ist, die vom Ausgang dieser Komparatorstufe (420) gesteuert werden und dazu bestimmt sind, einen ersten digitalen Wert (B), proportional zu dieser integrierten analogen Größe (VS), zu bestimmen;
- Mittel zur Speicherung dieses ersten digitalen Wertes (B);
- einen Rückkopplungskreis (450), dessen Eingang mit dem Ausgang dieses Speicherelements (441) verbunden ist und der umfasst:
• einen Wandler (451), der in der Lage ist, diesen ersten digitalen Wert (B) in ein analoges Signal (V_{DAC}) derselben Art wie die genannte analoge Größe (V_{E}) umzuwandeln,
• Mittel (452), um das genannte analoge Signal (V_{DAC}) von der genannten analoge Größe (V_{E}) zu subtrahieren,
• sowie Mittel (453) zur Verstärkung des Signals (V_{E} - V_{DAC}), das sich aus dieser Subtraktion ergibt, mit einem Zuwachs (2^{B}), der von der Zahl B der Bits des ersten digitalen Wertes abhängt,
- wobei der Ausgang des genannten Rückkopplungskreises (450) mit dem Eingang (415) dieser Integrationsstufe (410) verbunden ist, so dass letztere einen zweiten digitalen Wert (M), proportional zum so verstärkten analogen Signal (2^{b}.[V_{E} - V_{DAC}]) erzeugt;
- Mittel (460) zur Addition des ersten (B) und zweiten (M) digitalen Wertes um eine Zahl (N) zu bilden, die für die zu integrierende analoge Größe (V_{E}) repräsentativ ist.

7. Vorrichtung gemäß Anspruch 6, ***dadurch gekennzeichnet, dass*** der Binärzähler (442) ausgelagert und mehreren analogen/ digitalen Wandlern gemeinsam ist, die in jeder Spalte angeordnet sind.

8. Vorrichtung gemäß einem der Ansprüche 6 bis 7, ***dadurch gekennzeichnet, dass*** die Mittel zur Speicherung zwei Latch-Speicherelemente (441, 443) umfasst, die mit dem Ausgang des Binärzählers (442) verbunden sind.

9. Vorrichtung gemäß einem der Ansprüche 6 bis 8, ***dadurch gekennzeichnet, dass*** der genannte Rückkopplungskreis (450) ein Dekodierungssystem, das in der Lage ist, die Funktion der Digital-Analog-Wandlung durchzuführen, sowie eine Vielzahl von parallel geschalteten Kapazitäten, die einzeln über Schalter geschaltet werden können, umfasst.

10. Elektromagnetischer Strahlungsdetektor, insbesondere Infrarot-Strahlung, mit einer Matrix nebeneinander gestellter, elementarer Fühler, ***dadurch gekennzeichnet, dass*** er eine Vorrichtung nach einem der Ansprüche 6 bis 9 umfasst.

11. Elektromagnetischer Strahlungsdetektor gemäß Anspruch 10, ***dadurch gekennzeichnet, dass*** die Matrix eine einzige Zeile oder eine einzige Spalte umfasst.

12. Elektromagnetischer Strahlungsdetektor, gemäß einem der Ansprüche 10 bis 11, ***dadurch gekennzeichnet, dass*** es sich bei den elementaren Fühlern um Bolometer handelt.

## Claims

1. A method for digitizing an analog quantity (V_{E}) produced by a detector of electromagnetic radiation, in particular infrared radiation, said detector comprising a matrix of juxtaposed elementary sensors, whose interactions with said radiation generate said analog quantity (V_{E}), the method comprising the steps consisting, for each line or for each column of said matrix:
- in carrying out a first integration phase (302) of said analog quantity over a first time interval using an integrator stage (410);
- in ordering the interruption of said first integration phase (302) via a comparator stage (420) whereof one input is connected to the output of said integrator stage (410) and the other input to a reference circuit delivering a reference value (V_{ref});
- in converting the analog quantity thereby integrated (V_{S}) to a first numerical value (B) via a binary counter (442) and a memory element (441) connected to the output of said comparator stage (420);
- in storing said first numerical value (B) in the form of a first binary number representing the most significant bits;
said method being ***characterized in that*** it further comprises the steps consisting, for each line or for each column of said matrix:
- in converting said first numerical value (B) thereby obtained to an analog signal (V_{DAC}) similar to the analog quantity to be digitized (V_{E}) via an analog-to-digital converter (451);
- in subtracting said analog signal (V_{DAC}) from said analog quantity to be digitized (V_{E});
- in amplifying the signal (V_{E} - V_{DAC}) resulting from said subtraction with a gain representing said first numerical value (B);
- in carrying out a second integration phase (303) using said integrator stage (410), in order to produce a second numerical value (M) proportional to the analog signal thereby amplified 2^{B}.(V_{E} - V_{DAC}) and forming a second binary number representing the least significant bits;
- in adding said first (B) and second (M) numerical values in order to form a number (N) representative of said analog quantity to be integrated (V_{E}).

2. The method as claimed in claim 1, ***characterized in that*** said gain (2^{B}) has the value of the number two raised to the power of said first numerical value.

3. The method as claimed in claim 2, ***characterized in that*** said first numerical value (B) is increased by a unit before said conversion step, in order to correct the voltage offset presented by the comparator stage (420).

4. The method as claimed in one of the preceding claims, said integrator stage (410) comprising a capacitor (C), said method being ***characterized in that*** it comprises the steps consisting:
- in charging said capacitor (C) with the analog quantity to be converted;
- in discharging said capacitor (C) under a constant high intensity current (I) during the first integration phase (302);
- in recharging said capacitor (C) with a voltage (V_{E} - V_{DAC}) depending on the difference between the analog quantity to be integrated (V_{E}) and the result of the first conversion phase;
- in discharging said capacitor (C) under a constant low intensity current (I/2^{B}) during the second integration phase (303).

5. The method as claimed in one of the preceding claims, ***characterized in that*** the reference value (V_{ref}) is determined as a function of the sensitivity range of the detector.

6. A device for digitizing an analog quantity (V_{E}) produced by a detector of electromagnetic radiation, in particular infrared radiation, said detector comprising a matrix of juxtaposed elementary sensors, whose interactions with said radiation generate said analog quantity, said device comprising, the method comprising the steps consisting, for each line or for each column of said matrix:
- an integrator stage (410) comprising an operational amplifier (414), at least one capacitor (C) and an electrically controllable switching device (411) connected in parallel between the output and the reversing input (-) of said operational amplifier (414), said integrator stage (410) being suitable for integrating said analog quantity (V_{E}) when said switching device (411) is open;
- a comparator stage (420) comprising a single operational amplifier (421), and whereof the reversing input (-) is connected to the output of said integrator stage and the other input is connected to a reference circuit delivering a reference value (V_{ref});
- a binary counter (442) connected to two memory elements (441, 443), controlled by the output of said comparator stage (420) and suitable for determining a first numerical value (B) proportional to said integrated analog quantity (Vs);
- means for storing said first numerical value (B);
- a reverse feedback circuit (450), whereof the input is connected to the output of said memory element (441) and comprising:
▪ a converter (451) suitable for converting said first numerical value (B) to an analog signal (V_{DAC}) similar to said analog quantity (V_{E}),
▪ means (452) for subtracting said analog signal (V_{DAC}) from said analog quantity (V_{E}),
▪ and means (453) for amplifying the signal (V_{E} - V_{DAC}) resulting from said subtraction with a gain (2^{B}) depending on the number B of bits of said first numerical value,
- the output of said reverse feedback circuit (450) being connected to the input (415) of said integrator stage (410), so that the latter produces a second numerical value (M) proportional to the analog signal thereby amplified (2^{B}.[V_{E} - V_{DAC}]);
- means (460) for adding said first (B) and second (M) numerical values in order to form a number (N) representative of said analog quantity to be integrated (V_{E}).

7. The device as claimed in claim 6, ***characterized in that*** the binary counter (442) is offset and common to a plurality of analog-to-digital converters placed on each column.

8. The device as claimed in either of claims 6 and 7, ***characterized in that*** the storage means comprise two locking circuit memories (441, 443) connected to the output of the binary counter (442).

9. The device as claimed in one of claims 6 to 8, ***characterized in that*** said reverse feedback circuit (450) comprises a decoding system, suitable for carrying out the analog-to-digital conversion function, and a plurality of stores mounted in parallel and individually switchable using switches.

10. A detector of electromagnetic radiation, in particular infrared, comprising a matrix of juxtaposed elementary sensors, ***characterized in that*** it comprises a device as claimed in one of claims 6 to 9.

11. A detector of electromagnetic radiation as claimed in claim 10, ***characterized in that*** the matrix has a single line or a single column.

12. A detector of electromagnetic radiation as claimed in either of claims 10 and 11, **characterized in that** the elementary sensors are bolometers.
